# EUROPÄISCHE PATENTSCHRIFT

(11) **EP 4 428 935 B1**
(45) Veröffentlichungstag und Bekanntmachung des Hinweises auf die Patenterteilung: **04.12.2024**
(21) Anmeldenummer: 24000025.7
(22) Anmeldetag: 01.03.2024
(51) Int. Cl.: H01L 31/18, H01L 31/0687, H01L 31/0304, H01L 21/78

(54) **VERFAHREN ZUM ABLÖSEN EINER EPITAKTISCH AUF EINER HALBLEITERSCHEIBE AUFGEWACHSENEN III-V HALBLEITERSCHICHT**
METHOD FOR REMOVING A III-V SEMICONDUCTOR LAYER EPITAXIALLY GROWN ON A SEMICONDUCTOR WAFER
PROCÉDÉ POUR DÉTACHER UNE COUCHE ÉPITAXIALE DE SEMI-CONDUCTEUR III-V FORMÉE SUR UNE PLAQUETTE SEMI-CONDUCTRICE

(30) Priorität: 09.03.2023 DE 102023000892
(43) Veröffentlichungstag der Anmeldung: 11.09.2024
(73) Patentinhaber: AZUR SPACE Solar Power GmbH, 74072 Heilbronn (DE)
(72) Erfinder: Köstler, Wolfgang, 74074 Heilbronn (DE); Sommer, Steffen, 71732 Tamm (DE); Noumissing Sao, Chérubin, 74081 Heilbronn (DE)
(74) Vertreter: Koch Müller Patentanwaltsgesellschaft mbH

(56) Entgegenhaltungen:
- KR-A- 20160 047 759
- US-A1- 2009 035 534
- US-A1- 2016 155 881
- US-A1- 2016 293 489
- US-B1- 8 330 036
- WULF JANA ET AL: "Thin film GaAs solar cell enabled by direct rear side plating and patterned epitaxial lift-off", 2021 IEEE 48TH PHOTOVOLTAIC SPECIALISTS CONFERENCE (PVSC), IEEE, 20 June 2021 (2021-06-20), pages 1931 - 1935, XP033964245, DOI: 10.1109/PVSC43889.2021.9518788
- M. ENGLHARD ET AL: "A novel vacuum epitaxial lift-off (VELO) process for separation of hard GaAs substrate/carrier systems for a more green semiconductor LED production", MATERIALS SCIENCE IN SEMICONDUCTOR PROCESSING., vol. 71, 8 September 2017 (2017-09-08), UK, pages 389 - 395, XP055445533, ISSN: 1369-8001, DOI: 10.1016/j.mssp.2017.08.029
- WU FAN-LEI ET AL: "Improvement in separation rate of epitaxial lift-off by hydrophilic solvent for GaAs solar cell applications", SOLAR ENERGY MATERIALS AND SOLAR CELLS, ELSEVIER SCIENCE PUBLISHERS, AMSTERDAM, NL, vol. 122, 1 January 2014 (2014-01-01), pages 233 - 240, XP028817631, ISSN: 0927-0248, DOI: 10.1016/J.SOLMAT.2013.12.013
- CHIA-FENG LIN ET AL: "Chemical Lift-Off Process for Blue Light-Emitting Diodes", APPLIED PHYSICS EXPRESS, JAPAN SOCIETY OF APPLIED PHYSICS; JP, JP, vol. 3, no. 9, 092101, 27 August 2010 (2010-08-27), pages 1 - 3, XP001558420, ISSN: 1882-0778, DOI: 10.1143/APEX.3.092101
- LIN CHIA-FENG ET AL: "Fabrication of InGaN light-emitting diodes with embedded air-gap disks using laser-drilling and electrochemical processes", APPLIED PHYSICS EXPRESS, vol. 7, no. 7, 076501, 18 June 2014 (2014-06-18), JP, pages 1 - 4, XP093172869, ISSN: 1882-0778, DOI: 10.7567/APEX.7.076501

## Beschreibung

Aus Jana Wulf et al, "Thin Film GAAs solar cell enabled by direct rear side plating and patterned epitaxial lift-off" , ISE, Germany, 20-25 June 2021 IEEE 48th Photovoltaic Specialists Conference (PVSC), Fort Lauderdale, FL, USA, ISSN: 0160-8371, ist ein Ablöseprozess für GaAs Halbleiterschichten bekannt. Hierbei wird auf ein GaAs Substrat mittels eines MOVPE Epitaxieprozesses auf dem Substrat eine Zwischenschichtfolge, wobei die Zwischenschichtfolge eine Vielzahl von Schichten umfasst. Auf der Zwischenschichtfolge wird eine als GaAs Solarzelle ausgebildete Halbeiterschicht gitterangepasst zum Substrat aufgewachsen. Anschließend wird die Oberseite der GaAs Solarzelle mittels eines Maskenprozesses bis auf streifenförmige Öffnungen abgedeckt und mittels eines unselektiven Nassätzprozesses ein kreuzartiges Grabenmuster in die Bauelementeschicht zur Freilegung der Opferschicht erzeugt. In einem weiteren Prozessschritt wird eine strukturierte Metallfolie als Transferschicht derart ausgerichtet und auf die Oberfläche der Solarzelle aufgebracht, dass das Grabenmuster für das Einbringen einer HF Säure geöffnet bleibt. Anschließend wird mittels Flusssäure die 20 nm Dicke aus AlAs bestehende Opferschicht weggeätzt und die Halbleiterschicht bzw. die GaAs Solarzelle von der Unterlage abgelöst.

Vor diesem Hintergrund besteht die Aufgabe der Erfindung darin, eine Vorrichtung anzugeben, die den Stand der Technik weiterbildet.

Die Aufgabe wird durch ein Verfahren zum Ablösen einer epitaktisch aufgewachsenen Halbleiterschicht von einer Halbleiterscheibe mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Verfahren zum Ablösen einer epitaktisch auf einer Halbleiterscheibe aufgewachsenen III-V Halbleiterschicht bereitgestellt.

Die Halbleiterscheibe weist wenigstens einen Durchmesser von 100 mm oder 150 mm oder mehr auf.

Die Halbleiterscheibe ist als Substrat ausgebildet und weist eine Oberseite und eine Unterseite und eine Dicke oberhalb 100 µm auf. Die Halbleiterscheibe umfasst ein III-V Material oder ein Gruppe IV-Material oder besteht aus einem III-V Material oder Gruppe IV. Beispielsweise ist die Halbleiterscheibe aus InP oder GaAs oder aus Ge ausgebildet.

Auf der Oberseite der Halbleiterscheibe ist eine Pufferschicht mit einer Oberseite und einer Unterseite ausgebildet.

Auf der Oberseite der Pufferschicht ist eine Opferschicht ausgebildet und oberhalb der Opferschicht ist die Halbleiterschicht für eine Ausbildung von Bauelementen angeordnet, wobei die Halbleiterschicht eine Dicke oberhalb von 0,5 µm aufweist.

Die vorgenannten Schichten umfassen jeweils ein III-V Material oder bestehen aus einem III-V Material. Beispiele für III-V Materialen sind GaAs, InP, InGaP, InGaAsP.

oberhalb der Halbleiterschicht ist eine Trägerschicht ausgebildet, wobei die Trägerschicht und die Halbleiterschicht unterschiedliche Materialien umfassen. Vorzugsweise weist die Trägerschicht eine Dicke oberhalb 10 µm auf.

Die Opferschicht weist im Vergleich zu der Halbleiterschicht eine mindestens Faktor 10 höhere nasschemische Ätzrate auf.

Ferner sind die Opferschicht und die Pufferschicht und die Halbleiterschicht und die Trägerschicht jeweils ganzflächig ausgebildet oder sind wenigstens jeweils in einem zentralen Bereich der Halbleiterscheibe ganzflächig ausgebildet. Der zentrale Bereich weist zumindest einen Radius von 40 mm auf.

In einem Prozessschritt wird die Halbleiterscheibe in eine Aufnahmeeinrichtung eingebracht bzw. eingeführt. Die Aufnahmevorrichtung umfasst eine plane Unterlage auf der die Halbleiterscheibe abgelegt ist. In einer Ausführungsform ist die Unterlage mit der Halbleiterscheibe in wenigstens zwei Raumrichtungen elektromotorisch bewegbar.

In einem Prozessschritt werden aus einer Speichereinrichtung Positionsdaten von auf der Oberseite der Halbleiterscheibe angeordneten Punkten ausgelesen.

In einem Prozessschritt werden mittels einer Positioniereinrichtung, wobei die Positioniereinrichtung einen Laser umfasst, die anhand der Positionsdaten vorgegebenen Punkte angefahren und an wenigstens einem Teil der Punkte mittels des Lasers durch die Trägerschicht und die unterhalb der Trägerschicht ausgebildeten Schichten Löcher mit einem Boden erzeugt.

Der Laser wird derart gesteuert, dass der Boden des jeweiligen Loches innerhalb der Pufferschicht ausgebildet wird.

In einem nasschemischen Prozessschritt wird bei aufliegender Trägerschicht eine Ätzlösung in die Löcher eingebracht, um die Opferschicht wenigstens teilweise zu entfernen und die Halbleiterschicht abzulösen.

Es sei angemerkt, dass die angeführten Prozessschritte in der angegebenen Reihenfolge durchgeführt werden.

Es sei angemerkt, dass die Ätzlösung derart ausgebildet ist, dass die Trägerschicht und die Halbleiterschicht möglichst nicht angegriffen wird. Anders ausgedrückt, die Ätzlösung löst selektiv die Opferschicht auf. Hierbei ist es von Vorteil eine möglichst hohe Selektivität zu erzielen, d.h. die Opferschicht schnell wegzuätzen.

Des Weiteren sei angemerkt, dass die oberhalb der Halbleiterschicht ausgebildete Trägerschicht wenigstens eine andere Stöchiometrie als die Halbleiterschicht aufweist.

Vorzugsweise ist der zentrale Bereich unstrukturiert, d.h. die Schichten weisen jeweils eine plane Ebene auf. Es versteht sich aber, dass Teile insbesondere in der Nähe des Rands der Hableiterscheibe eine Topographie aufweisen.

Es sei auch angemerkt, dass in einer Weiterbildung der zentrale Bereich unstrukturiert ist, jedoch von dem Untergrund bedingte Topographie aufweist. Hierbei sind mit dem Begriff "Untergrund" die Schichten zwischen Substrat und der Trägerschicht bezeichnet. Anders ausgedrückt, die Trägerschicht und oder eventuell auf der Trägerschicht aufliegende weitere Schichten sind ganzflächig und jeweils nicht selbst strukturiert.

Ein Vorteil des vorliegenden Verfahrens ist es, dass die Trägerschicht als auch die darunterliegenden Schichten erst mittels des Lasers geöffnet bzw. strukturiert werden. Aufwändige Masken- und Ausrichtungsverfahrensschritte, um strukturierte Schichten aufeinander auszurichten, erübrigen sich.

Ein weiterer Vorteil ist, dass mittels eines hochselektiven nasschemischen Ätzschritts sich die Opferschicht weitestgehend materialspezifisch ätzen lässt. Insbesondere in Verbindung mit den durch den Laser erzeugten sehr präzisen Löchern, lässt sich die Bauelementnutzfläche erheblich vergrößern. Eine Verwendung von unterschiedlichen Ätzlösungen mit denen die Gräben verbreitern werden, erübrigt sich.

Ein anderer Vorteil ist es, dass sich mittels des Lasers beliebige Muster auf einfache und schnelle Weise erzeugen lassen. Anders ausgedrückt, lassen sich unterschiedliche Bauelementstrukturen auf einfache Weise ohne aufwändige Maskenprozesse erzeugen. Insbesondere zeigt sich, dass sich einer 100 mm Halbleiterscheibe schnell eine Vielzahl von Löchern erzeugen lassen. Mit einer Vielzahl wird vorliegend eine Anzahl von Löchern in einem Bereich zwischen 1000 - 10.000 Löcher oder ein Bereich zwischen 4.000 und 6.000 Löcher verstanden. Es zeigte sich, dass sich durch die vorgenannte Vielzahl von Löchern sich die Halbleiterschicht einfach und zuverlässig ablösen lässt.

In einer Weiterbildung wird an jedem Punkt mittels des Lasers genau ein Loch erzeugt. Anschließend wird der Laser zu einem weiteren Punkt verfahren, um mittels des Lasers ein weiteres Loch zu erzeugen.

In einer anderen Weiterbildung werden die Löcher ausschließlich mittels des Lasers erzeugt. Wie bereits ausgeführt, ist es vorteilhaft, dass eine Vorstrukturierung insbesondere mittels aufwändigen und teuren Maskenprozessen entfällt. Es versteht sich, dass alle auf der Pufferschicht aufliegenden Schichten mittels des Lasers durchbohrt werden, wobei in manchen Ausführungsformen die aufliegenden Schichten neben den III-V Halbleiterschichten insbesondere auch Metallschichten und / oder Kunststoffschichten umfassen.

In einer Ausführungsform sind die Löcher voneinander beabstandet. Vorzugsweise liegt der Abstand zwischen zwei unmittelbar benachbarten Löchern in einem Bereich zwischen 0,001 mm und 10 mm oder zwischen 2mm und 5 mm.

In einer Weiterbildung weisen die Löcher einen Durchmesser in einem Bereich zwischen 1 µm und 100 µm oder zwischen 10 µm und 60 µm mm oder 30 µm ± 5 µm auf. Vorzugsweise sind die Löcher kreisförmig oder oval ausgebildet. In einer Weiterbildung weisen die Löcher eine nahezu senkrechte oder genau eine senkrechte Seitenwand auf. Unter dem Begriff "nahezu" wird eine Abweichung von ± 10 ° von der Senkrechten verstanden.

In einer Weiterbildung weicht der Durchmesser der Löcher an der Öffnung um weniger als 25% oder weniger als 10% von dem Durchmesser an dem Boden ab. Vorzugsweise ist der Durchmesser an der Öffnung größer oder gleich groß wie der Durchmesser an dem Boden des jeweiligen Lochs.

Alternativ sind die Löcher derart aneinandergereiht, dass die Löcher sich aneinanderfügen. Unter aneinanderfügen wird vorliegend verstanden, dass sich zwischen zwei benachbarten Löchern in Höhe der Öffnung der Löcher eine Seitenwand mit einer Dicke kleiner als 1 mm oder keine Seitenwand ausgebildet ist.

In einer anderen Ausführungsform werden die Löcher entlang der Linie derart aneinandergereiht, dass sich eine grabenförmige Struktur oder eine Aneinanderreihung von Langlöchern ausbildet. Untersuchungen haben gezeigt, dass sich mittels der grabenförmigen Struktur die Dauer der nasschemischen Ätzung verkürzen lässt.

In einer Weiterbildung werden die Löcher entlang von mehreren Linien angeordnet, wobei die Linien ein kreuzförmiges Muster oder die Außenseiten eines Quadrates oder mehrerer Quadrate ausbilden. Durch die Anzahl der Linien und oder die Anzahl der Quadrate lässt sich die Dauer der nasschemischen Ätzung beeinflussen.

In einer anderen Ausführungsform umfasst die Trägerschicht eine Metall-schicht und / oder ein III-V Material oder die Trägerschicht besteht aus einer Metallschicht oder besteht aus einem III-V Material.

In einer Weiterbildung weist die Trägerschicht eine Dicke zwischen 20 µm und 500 µm oder zwischen 50 µm und 300 µm oder zwischen 100 µm und 200 µm. In einer Weiterbildung umfasst oder besteht die Metallschicht aus mehreren unterschiedlichen Metallschichten.

In einer Weiterbildung wird die Trägerschicht stoffschlüssig auf der Halbleiterschicht ausgebildet.

In einer anderen Ausführungsform ist zwischen der Trägerschicht und der Metallschicht eine Distanzschicht ausgebildet. Die Distanzschicht weist eine Dicke zwischen 0,1 µm und 10 µm oder zwischen 0,3 µm und 7 µm oder zwischen 0,5 µm und 2 µm auf.

In einer Weiterbildung ist die Distanzschicht als leitende oder als halbleitende oder als isolierende Halbleiterschicht ausgebildet. In einer anderen Ausführungsform ist die Distanzschicht als dielektrische Schicht ausgebildet.

In einer Ausführungsform wird die Distanzschicht insbesondere bei der Ausführung als dielektrische Schicht strukturiert, um die metallische Trägerschicht mit der Halbleiterschicht elektrisch zu verbinden. Hierbei ist die metallische Trägerschicht als Kontaktschicht ausgebildet. In einer Weiterbildung weist die dielektrische Schicht für den elektrischen Anschluss mittels der Metallschicht Aussparungen, die in einem Bereich von 5% bis 20% oder im Bereich von 10% liegen.

Ist in der Halbleiterschicht ein Halbleiterbauelement ausgebildet bzw. ist die Halbleiterschicht selbst das Bauelement lässt sich durch die Kontaktschicht das elektrische Bauelement bzw. die Halbleiterschicht elektrisch vorteilhaft und zuverlässig anschließen.

Es ersteht sich hierbei, den Anschlusswiderstand möglichst gering auszubilden. Vorzugsweise liegt der Kontaktwiderstand in einem Bereich zwischen 0,01 Ohm und 2 Ohm oder in einem Bereich zwischen 0,1 Ohm und 0,5 Ohm.

In einer Weiterbildung wird eine Transferschicht auf der Trägerschicht vor oder nach dem Erzeugen der Löcher vorzugsweise stoffschlüssig auf der Trägerschicht angeordnet. Wird die Transferschicht vor dem Erzeugen der Löcher angeordnet, werden die Löcher mittels des Lasers durch die Transferschicht hindurch erzeugt.

In einer anderen Weiterbildung umfasst die Transferschicht eine Metallschicht und / oder eine Kunststoffschicht oder die Transferschicht besteht aus einer Metallschicht oder besteht aus einer Kunststoffschicht.

In einer Ausführungsform umfasst oder besteht die Transferschicht aus einem mehrlagigen Schichtsystem. In einer Ausführungsform weist die Trägerschicht eine Dicke zwischen 20 µm und 500 µm oder zwischen 50 µm und 300 µm oder zwischen 100 µm und 200 µm auf.

In einer anderen Ausführungsform weist die Opferschicht eine Dicke zwischen 5 nm und 20 nm auf. In einer Weiterbildung weist die Opferschicht im Vergleich zu der Halbleiterschicht eine mindestens um einen Faktor 100 oder mindestens einen Faktor 500 höhere nasschemische Ätzrate auf.

In einer anderen Ausführungsform weist die Pufferschicht eine Dicke in einem Bereich von 0,5 µm bis 50 µm oder in einem Bereich zwischen 1,0 µm und 30 µm oder in einen Bereich zwischen 5 µm und 10 µm auf.

In einer Weiterbildung weist die Pufferschicht an einer Unterseite, die in Richtung des Substrats ausgebildet ist, eine gleiche oder eine unterschiedliche Gitterkonstante zu einer in Richtung der Opferschicht ausgebildeten Oberseite auf. Es sei angemerkt, dass die Gitterkonstante an der Unterseite mit der Gitterkonstante des Substrats übereinstimmt.

Es versteht sich, dass mit der Gitterkonstanten an der Oberseite der Pufferschicht die Gitterkonstante der Halbleiterschicht bestimmt wird. Sofern die beiden Gitterkonstanten der Pufferschicht gleich sind, entspricht die Gitterkonstante des Substrats der Gitterkonstante der Halbleiterschicht. Anders ausgedrückt, der gesamte Schichtstapel der Halbleiterschichten ist zueinander gitterangepasst.

Entsprechendes gilt, sofern keine weiteren Schichten zwischen der Oberseite der Halbleiterscheibe und der Unterseite der Pufferschicht ausgebildet sind, auch dann stimmt die Gitterkonstante der Oberseite der Halbleiterscheibe mit der Gitterkonstante der Unterseite überein.

Sind die Gitterkonstanten der Pufferschicht unterschiedlich, umfasst die Pufferschicht in einer anderen Weiterbildung ein metamorphes Schichtsystem. Anders ausgedrückt, die Pufferschicht ist als metamorphe Puffer ausgebildet. In einer anderen Weiterbildung ist die Gitterkonstante an der Oberseite der Pufferschicht größer als die Gitterkonstante an der Unterseite der Pufferschicht.

In einer Ausführungsform umfasst die Opferschicht AlAs oder besteht aus AlAs besteht und / oder die Opferschicht InGaP umfasst oder besteht aus InGaP.

In einer Weiterbildung weist die Opferschicht im Vergleich zu dem Material der Halbleiterscheibe und / oder im Vergleich zu der Halbleiterschicht eine mindestens um Faktor 10 oder mindestens einen Faktor 100 oder mindestens einen Faktor 500 höhere nasschemische Ätzrate auf.

In einer anderen Weiterbildung weist die Opferschicht im Vergleich zu der Pufferschicht eine mindestens um einen Faktor 10 oder mindestens um einen Faktor 100 oder mindestens um einen Faktor 500 höhere nasschemische Ätzrate auf.

Es versteht sich, dass die Opferschicht eine im Vergleich zu der Pufferschicht und im Vergleich zu der Halbleiterschicht unterschiedliche III-V Verbindung aufweist.

In einer Ausführungsform weist die Halbleiterschicht eine Dicke in einem Bereich von 1 µm und 150 µm oder in einem Bereich von 10 µm und 80 µm oder in einem Bereich von 20 µm und 40 µm auf.

In einer Weiterbildung umfasst oder besteht die Halbleiterschicht aus GaAs oder aus InGaAs oder aus InGaAsP oder aus (Al)InGaP.

In einer anderen Weiterbildung besteht die Halbleiterschicht aus genau einer Schicht oder aus einer Vielzahl von Halbleiterschichten. Vorzugsweise weisen die Vielzahl von III-V Halbleiterschichten unterschiedliche III-V Verbindungen auf.

In einer Weiterbildung umfasst oder besteht die Halbleiterschicht aus einer III-V Mehrfachsolarzelle. In einer anderen Weiterbildung umfasst die Halbleiterschicht GaAs oder InGaAs oder die Halbleiterschicht besteht aus GaAs oder InGaAs.

In einer Ausführungsform ist die Halbleiterschicht als eine hochsperrende Diode mit einer Sperrspannung oberhalb 200 V ausgebildet.

In einer anderen Ausführungsform wird zwischen der Pufferschicht und der Halbleiterscheibe eine Zwischenschicht angeordnet.

In einer anderen Ausführungsform weist die Zwischenschicht eine andere Materialzusammensetzung oder zumindest eine andere Stöchiometrie als die beiden mit der Zwischenschicht stoffschlüssig verbundenen Schichten auf.

In einer Weiterbildung weist die Zwischenschicht eine Dicke zwischen 2 nm und 20 nm auf. In einer anderen Weiterbildung weist die Zwischenschicht im Vergleich mit dem Material der Halbleiterscheibe eine um wenigstens den Faktor 10 oder wenigstens um den Faktor 100 oder wenigstens um den Faktor 500 höhere nasschemische Ätzrate auf.

In einer Ausführungsform umfasst die Zwischenschicht ein III-V Material oder besteht aus einem III-V Material.

In einer anderen Ausführungsform wird nach dem Ablösen die Halbleiterschicht auf eine Unterlage abgelegt, um weitere Verfahrensschritte durchzuführen.

In einer Weiterbildung wird nach dem Ablösen in einem weiteren nasschemischen Schritt die Opferschicht von der Unterseite der Halbleiterschicht vollständig entfernt.

In einer Ausführungsform fehlt in einem Randbereich wenigstens eine oder keine der vorgenannten Schichten, wobei der Randbereich eine laterale Erstreckung kleiner als 3% des Radius der Halbleiterscheibe umfasst.

In einer anderen Ausführungsform wird mittels der Aufnahmevorrichtung die Halbleiterscheibe auf eine laterale Genauigkeit von +/- 100µm oder +/-50 µm oder +/-10 µm justiert.

In einer Weiterbildung ist zwischen der Trägerschicht und der Halbleiterschicht eine dielektrische Schicht ausgebildet. Vorzugsweise Ist die dielektrische Schicht strukturiert, sodass die Halbleiterschicht mittels der Metallschicht elektrisch kontaktiert wird.

In einer anderen Weiterbildung umfassen die Opferschicht und Pufferschicht dasselbe Material oder bestehen aus demselben Material oder weisen dieselbe Verbindung auf. Insbesondere weisen die Opferschicht und die Pufferschicht die gleiche Stöchiometrie auf.

In einer Ausführungsform wird mittels einer Steuerung die Dauer und / oder der Stärke des Laserstrahls verändert, um die geometrische Form und / oder die Tiefe der Löcher einzustellen. In einer anderen Ausführungsform erfolgt eine Steuerung des Lasers mittels einer Endpunktdetektion.

In einer anderen Weiterbildung wird für eine Steuerung des Lasers sowohl die Dauer als auch die Stärke verändert als auch eine Endpunktdetektion verwendet.

In einer Ausführungsform wird zwischen der Opferschicht und der Halbleiterschicht eine weitere Pufferschicht ausgebildet, so dass die Opferschicht zwischen der Pufferschicht und der weiteren Pufferschicht als eine Sandwichstruktur ausgebildet wird. Es versteht sich, dass die weitere Pufferschicht im Vergleich zu der Opferschicht wenigstens eine andere Stöchiometrie aufweist, vorzugsweise weisen die Schichten unterschiedliche III-V Verbindungen auf.

In einer anderen Ausführungsform weist die weitere Pufferschicht eine Dicke In einem Bereich von 0,5 µm bis 50 µm oder in einem Bereich zwischen 1,0 µm und 30 µm oder in einen Bereich zwischen 5 µm und 10 µm auf.

In einer Weiterbildung bestehen oder umfassen die Pufferschicht und die weitere Pufferschicht die gleichen III-V Verbindungen oder unterschiedliche III-V Verbindungen.

In einer anderen Ausführungsform wird zwischen der weiteren Pufferschicht und der Halbleiterschicht eine Ätzstoppschicht ausgebildet. Es versteht sich, dass die Ätzstoppschicht im Vergleich zu der Halbleiterschicht und im Vergleich zu der weiteren Pufferschicht wenigstens eine andere Stöchiometrie aufweist, vorzugsweise weisen die Schichten zueinander unterschiedliche III-V Verbindungen.

In einer Ausführungsform weisen die weitere Pufferschicht und die Halbleiterschicht die gleiche III-V Verbindung jedoch eine unterschiedliche Verbindung zu der Opferschicht auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: einen Querschnitt auf einen Ausschnitt einer Halbleiterscheibe in Form einer Schichtstruktur,
- Figur 2: einen Querschnitt auf eine weitere Schichtstruktur.

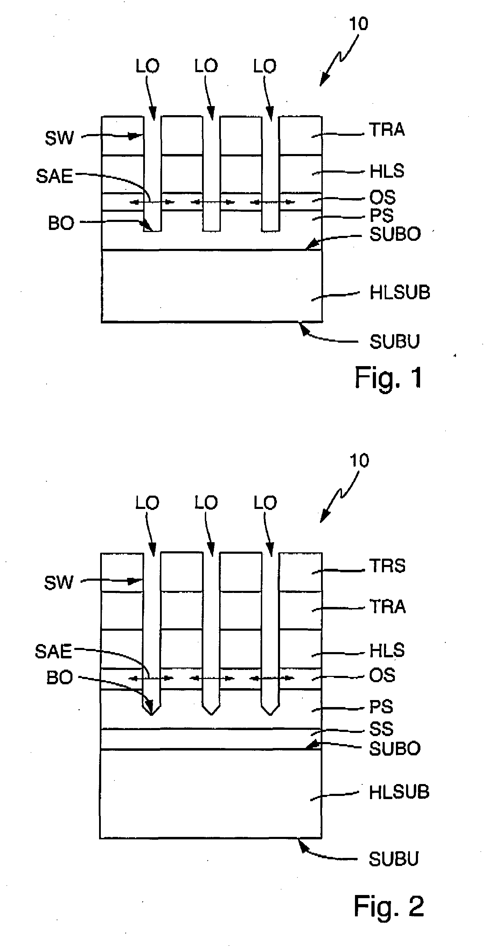

Die Abbildung der Figur 1 zeigt einen Querschnitt auf einen Ausschnitt einer Halbleiterscheibe HLSUB in Form einer Schichtstruktur 10.

Die Schichtstruktur 10 umfasst die als Substrat ausgebildete Halbleiterscheibe HLSUB, wobei die Halbleiterscheibe eine Oberseite SUBO und eine Unterseite SUBU aufweist. Auf der Oberseite SUBO ist eine Pufferschicht PS ausgebildet. Auf der Oberseite der Pufferschicht PS ist eine Opferschicht OS und oberhalb der Opferschicht OS ist eine Halbleiterschicht HLS für eine Ausbildung von Bauelementen angeordnet. Die Halbleiterschicht HLS weist eine Dicke oberhalb von 0,5 µm.

Oberhalb der Halbleiterschicht HLS ist eine Trägerschicht TRA ausgebildet. Von der Oberseite der Trägerschicht TRA sind mittels eine Lasers drei Löcher LO erzeugt worden. Die Löcher LO weisen senkrechte Seitenwände SW und einen Boden BO auf.

Nach dem Erzeugen der Löcher LO wird die Opferschicht OS mittels einer Ätzlösung SAE nasschemisch entfernt.

In der Abbildung der Figur 2 ist ein Querschnitt auf eine weitere Schichtstruktur 10 dargestellt. Im Folgenden werden nur die Unterschiede zu der Abbildung der Figur 1 erläutert.

Auf der Trägerschicht TRA ist eine Transferschicht TRS ausgebildet. Indem die Löcher LO nach der Ausbildung der Transferschicht TRS erzeugt worden sind, beginnen die Löcher LO auf der Oberfläche der Transferschicht TRS. Der Boden BO der Löcher ist im Unterschied zu der Abbildung der Figur 1 konisch abgebildet, um die geometrische Variationsbreite des Bodens BO zu verdeutlichen.

Des Weiteren ist zwischen der Pufferschicht PS eine Ätzstoppschicht SS angeordnet. Ein Vorteil der Ätzstoppschicht SS ist es, dass sich die Oberfläche der Halbleiterscheibe HLSUB einfacher reinigen lässt.

## Patentansprüche

1. Verfahren zum Ablösen einer epitaktisch auf einer Halbleiterscheibe aufgewachsenen III-V Halbleiterschicht, wobei die Halbleiterscheibe wenigstens einen Durchmesser von 100 mm aufweist,
- die Halbleiterscheibe als Substrat ausgebildet ist und ein III-V Material oder ein Gruppe IV-Material umfasst oder aus einem III-V Material oder Gruppe IV besteht,
- die Halbleiterscheibe eine Oberseite und eine Unterseite aufweist,
- auf der Oberseite eine Pufferschicht ausgebildet ist,
- auf der Oberseite der Pufferschicht eine Opferschicht ausgebildet ist,
- oberhalb der Opferschicht die Halbleiterschicht für eine Ausbildung von Bauelementen angeordnet ist, wobei die Halbleiterschicht eine Dicke oberhalb von 0,5 µm aufweist,
die vorgenannten Schichten jeweils ein III-V Material umfassen oder aus einem III-V Material bestehen,
- oberhalb der Halbleiterschicht eine Trägerschicht ausgebildet ist, wobei die Trägerschicht und die Halbleiterschicht unterschiedliche Materialien umfassen und die Trägerschicht eine Dicke oberhalb 10 µm aufweist,
- die Opferschicht im Vergleich zu der Halbleiterschicht eine mindestens Faktor 10 höhere nasschemische Ätzrate aufweist,
- die Opferschicht und die Pufferschicht und die Halbleiterschicht und die Trägerschicht jeweils ganzflächig ausgebildet sind oder jeweils in einem zentralen Bereich der Halbleiterscheibe ganzflächig ausgebildet sind, wobei der zentrale Bereich zumindest einen Radius von 40 mm aufweist,
**dadurch gekennzeichnet, dass**
- in einem Prozessschritt die Halbleiterscheibe in eine Aufnahmeeinrichtung eingebracht wird,
- in einem Prozessschritt aus einer Speichereinrichtung Positionsdaten von auf der Oberseite der Halbleiterscheibe angeordneten Punkten ausgelesen werden und die Punkte entlang einer Linie angeordnet sind,
- In einem Prozessschritt ein Laser die anhand der Positionsdaten vorgegebenen Punkte anfährt und an wenigstens einem Teil der Punkte mittels des Lasers durch die Trägerschicht und die unterhalb der Trägerschicht ausgebildeten Schichten Löcher mit einem Boden erzeugt werden, wobei der Laser derart gesteuert wird, dass der Boden des jeweiligen Loches innerhalb der Pufferschicht ausgebildet wird,
- in einem nasschemischen Prozessschritt bei aufliegender Trägerschicht eine Ätzlösung in die Löcher eingebracht wird, um die Opferschicht wenigstens teilweise zu entfernen und die Halbleiterschicht abzulösen,
- die angeführten Prozessschritte in der angegebenen Reihenfolge durchgeführt werden.

2. Verfahren nach Anspruch 1, **dadurch gekennzeichnet, dass** die Löcher ausschließlich mittels des Lasers erzeugt werden.

3. Verfahren nach Anspruch 1 oder Anspruch 2, **dadurch gekennzeichnet, dass** die Löcher entlang der Linie derart aneinandergereiht werden, dass sich eine grabenförmige Struktur oder eine Aneinanderreihung von Langlöchern ausbildet.

4. Verfahren nach einem der vorangegangenen Ansprüche, **dadurch gekennzeichnet, dass** die Trägerschicht eine Metallschicht und / oder ein III-V Material umfasst.

5. Verfahren nach einem der vorangegangenen Ansprüche, **dadurch gekennzeichnet, dass** eine Transferschicht auf der Trägerschicht vor oder nach dem Erzeugen der Löcher angeordnet wird.

6. Verfahren nach Anspruch 5, **dadurch gekennzeichnet, dass** die Transferschicht eine Metallschicht und / oder eine Kunststoffschicht umfasst oder aus einer Metallschicht oder einer Kunststoffschicht besteht und die Trägerschicht eine Dicke zwischen 20 µm und 500 µm aufweist.

7. Verfahren nach einem der vorangegangenen Ansprüche, **dadurch gekennzeichnet, dass** die Opferschicht eine Dicke zwischen 5 nm und 20 nm aufweist und die Opferschicht im Vergleich zu der Halbleiterschicht eine mindestens einen Faktor 100 höhere nasschemische Ätzrate aufweist.

8. Verfahren nach einem der vorangegangenen Ansprüche, **dadurch gekennzeichnet, dass** die Pufferschicht eine Dicke in einem Bereich von 0,5 µm bis 50 µm aufweist und die Pufferschicht im Vergleich zu dem Material der Halbleiterscheibe und / oder im Vergleich zu der Halbleiterschicht eine mindestens Faktor 10 oder mindestens einen Faktor 100 höhere nasschemische Ätzrate aufweist.

9. Verfahren nach einem der vorangegangenen Ansprüche, **dadurch gekennzeichnet, dass** die Halbleiterschicht eine Vielzahl von unterschiedlichen III-V Halbleiterschichten umfasst und insbesondere als III-V Mehrfachsolarzelle ausgebildet ist.

10. Verfahren nach einem der vorangegangenen Ansprüche, **dadurch gekennzeichnet, dass** die Opferschicht AlAs umfasst oder aus AlAs besteht oder die Opferschicht InGaP umfasst oder aus InGaP besteht.

11. Verfahren nach einem der vorangegangenen Ansprüche, **dadurch gekennzeichnet, dass** in einem Randbereich wenigstens eine oder keine der vorgenannten Schichten fehlt, wobei der Randbereich eine laterale Erstreckung kleiner als 3% des Radius der Halbleiterscheibe umfasst.

12. Verfahren nach einem der vorangegangenen Ansprüche, **dadurch gekennzeichnet, dass** zwischen der Trägerschicht und der Halbleiterschicht eine dielektrische Schicht ausgebildet ist, wobei die dielektrische Schicht strukturiert ist, sodass die Halbleiterschicht mittels der Metallschicht elektrisch kontaktiert wird.

13. Verfahren nach einem der vorangegangenen Ansprüche, **dadurch gekennzeichnet, dass** Opferschicht und Puffersicht dasselbe Material umfassen oder aus demselben Material bestehen oder die Opferschicht und die Pufferschicht die gleiche Stöchiometrie aufweisen.

14. Verfahren nach einem der vorangegangenen Ansprüche, **dadurch gekennzeichnet, dass** mittels einer Steuerung der Dauer und / oder der Stärke des Laserstrahls die geometrische Form und / oder die Tiefe der Löcher beeinflusst wird.

## Claims

1. Method for detaching a III-V semiconductor layer epitaxially grown on a semiconductor wafer, wherein the semiconductor wafer has at least a diameter of 100 mm,
- the semiconductor layer is formed as a substrate and comprises a III-V material or a group IV material or consists of a III-V material or group IV material,
- the semiconductor wafer has an upper side and a lower side,
- a buffer layer is formed on the upper side,
- a sacrificial layer is formed on the upper side of the buffer layer,
- the semiconductor layer is arranged for a construction of components above the sacrificial layer, wherein the semiconductor layer has a thickness above 0.5 µm,
- the aforesaid layers each comprise a III-V material or consist of a III-V material,
- a carrier layer is formed above the semiconductor layer, wherein the carrier layer and the semiconductor layer comprise different materials and the carrier layer has a thickness above 10 µm,
- the sacrificial layer has a wet-chemical etching rate higher by comparison with the semiconductor layer by at least a factor of 10,
- the sacrificial layer and the buffer layer and the semiconductor layer and the carrier layer are each formed over the whole area or are each formed over the whole area in a central region of the semiconductor wafer, wherein the central region has at least a radius of 40 mm,
**characterised in that**
- in a process step the semiconductor wafer is introduced into a mounting device,
- in a process step position data of points arranged on the upper side of the semiconductor wafer are read out of a memory device and the points are arranged along a line,
- in a process step a laser moves to the points predetermined on the basis of the position data and holes with a base are produced at at least a part of the points by means of the laser through the carrier layer and the layers formed underneath the carrier layer, wherein the laser is controlled in such a way that the base of the respective hole is formed within the buffer layer,
- with the carrier layer support an etching solution is introduced into the holes in a wet-chemical process step so as to at least partly remove the sacrificial layer and detach the semiconductor layer,
- the listed process steps are performed in the indicated sequence.

2. Method according to claim 1, **characterised in that** the holes are produced exclusively by means of the laser.

3. Method according to claim 1 or 2, **characterised in that** the holes are arranged in a row along the line in such a way that a trench-shaped structure or a row of slots forms.

4. Method according to any one of the preceding claims, **characterised in that** the carrier layer comprises a metal layer and/or a III-V material.

5. Method according to any one of the preceding claims, **characterised in that** a transfer layer is arranged on the carrier layer prior to or after production of the holes.

6. Method according to claim 5, **characterised in that** the transfer layer comprises a metal layer and/or a synthetic material layer or consists of a metal layer or a synthetic material layer and the carrier layer has a thickness between 20 µm and 500 µm.

7. Method according to any one of the preceding claims, **characterised in that** the sacrificial layer has a thickness between 5 nm and 20 nm and the sacrificial layer has a wet-chemical etching rate higher by comparison with the semiconductor layer by at least a factor of 100.

8. Method according to any one of the preceding claims, **characterised in that** the buffer layer has a thickness in a range of 0.5 µm to 50 µm and the buffer layer has a wet-chemical etching rate higher by comparison with the material of the semiconductor wafer and/or by comparison with the semiconductor layer by at least a factor of 10 or at least a factor of 100.

9. Method according to any one of the preceding claims, **characterised in that** the semiconductor layer comprises a plurality of different III-V semiconductor layers and, in particular, is constructed as a III-V multiple solar cell.

10. Method according to any one of the preceding claims, **characterised in that** the sacrificial layer comprises AlAs or consists of AlAs or the sacrificial layer comprises InGaP or consists of InGaP.

11. Method according to any one of the preceding claims, **characterised in that** at least one or none of the aforesaid layers is absent in an edge region, wherein the edge region has a lateral dimension less than 3% of the radius of the semiconductor wafer.

12. Method according to any one of the preceding claims, **characterised in that** a dielectric layer is formed between the carrier layer and the semiconductor layer, wherein the dielectric layer is structured so that the semiconductor layer is electrically contacted by means of the metal layer.

13. Method according to any one of the preceding claims, **characterised in that** the sacrificial layer and buffer layer comprise the same material or consist of the same material or the sacrificial layer and the buffer layer have the same stoichiometry.

14. Method according to any one of the preceding claims, **characterised in that** the geometric shape and/or the depth of the holes is or are influenced by means of control of the duration and/or strength of the laser beam.

## Revendications

1. Procédé pour détacher une couche semi-conductrice III-V formée par croissance épitaxiale sur une plaquette semi-conductrice, laquelle plaquette semi-conductrice présente un diamètre d'au moins 100 mm,
- la plaquette semi-conductrice faisant office de substrat et comprenant un matériau III-V ou un matériau du groupe IV ou étant constituée d'un matériau III-V ou du groupe IV,
- la plaquette semi-conductrice possédant une face supérieure et une face inférieure,
- une couche tampon étant formée sur la face supérieure,
- une couche sacrificielle étant formée sur la face supérieure de la couche tampon,
- au-dessus de la couche sacrificielle, la couche semi-conductrice étant disposée pour une formation d'éléments de construction, la couche semi-conductrice possédant une épaisseur supérieure à 0,5 µm,
les couches susmentionnées comprenant chacune un matériau III-V ou étant constituées d'un matériau III-V,
- une couche de support étant formée au-dessus de la couche semi-conductrice, la couche de support et la couche semi-conductrice comprenant des matériaux différents et la couche de support possédant une épaisseur supérieure à 10 µm,
- la couche sacrificielle possédant une vitesse de gravure chimique par voie humide au moins 10 fois supérieure à la couche semi-conductrice,
- la couche sacrificielle, la couche tampon, la couche semi-conductrice et la couche de support étant chacune formées sur une surface complète ou formées sur une surface complète dans une zone centrale de la plaquette semi-conductrice, laquelle zone centrale possède un rayon d'au moins 40 mm,
**caractérisé en ce que**
- dans une étape de processus, la plaquette semi-conductrice est insérée dans un dispositif de logement,
- dans une étape de processus, les données positionnelles de points disposés sur la face supérieure de la plaquette semi-conductrice sont lues à partir d'un dispositif de mémorisation et ces points sont disposés le long d'une ligne,
- dans une étape de processus, un laser parcourt les points prédéfinis par les données positionnelles et, sur au moins une partie des points, des trous dotés d'un fond sont créés au moyen du laser à travers la couche de support et les couches formées au-dessous de la couche de support, le laser étant contrôlé de telle façon que le fond de chaque trou est créé à l'intérieur de la couche tampon et,
- dans une étape de processus chimique par voie humide, la couche de support étant appliquée, une solution de gravure est injectée dans les trous, pour éliminer au moins partiellement la couche sacrificielle et détacher la couche semi-conductrice,
- les étapes de processus susmentionnées étant exécutées dans l'ordre indiqué.

2. Procédé selon la revendication 1, **caractérisé en ce que** les trous sont réalisés uniquement au moyen du laser.

3. Procédé selon la revendication 1 ou la revendication 2, **caractérisé en ce que** les trous sont juxtaposés le long de la ligne de telle sorte qu'il se forme une structure en forme de tranchée ou une juxtaposition de trous longitudinaux.

4. Procédé selon une des revendications précédentes, **caractérisé en ce que** la couche de support comprend une couche métallique et/ou un matériau III-V.

5. Procédé selon une des revendications précédentes, **caractérisé en ce qu'**une couche de transfert est disposée sur la couche de support avant ou après la réalisation des trous.

6. Procédé selon la revendication 5, **caractérisé en ce que** la couche de transfert comporte une couche métallique et/ou une couche de matière plastique ou est constituée d'une couche métallique ou d'une couche de matière plastique et la couche de support possède une épaisseur de 20 µm à 500 µm.

7. Procédé selon une des revendications précédentes, **caractérisé en ce que** la couche sacrificielle possède une épaisseur de 5 nm à 20 nm et que la couche sacrificielle possède une vitesse de gravure chimique par voie humide au moins 100 fois supérieure à la couche semi-conductrice.

8. Procédé selon une des revendications précédentes, **caractérisé en ce que** la couche tampon possède une épaisseur située sur une plage de 0,5 µm à 50 µm et que la couche tampon possède une vitesse de gravure chimique par voie humide au moins 10 fois ou au moins 100 fois supérieure au matériau de la couche semi-conductrice et/ou à la couche semi-conductrice.

9. Procédé selon une des revendications précédentes, **caractérisé en ce que** la couche semi-conductrice comporte une multitude de couches semi-conductrices III-V différentes et en particulier est constituée comme une cellule solaire multiple III-V.

10. Procédé selon une des revendications précédentes, **caractérisé en ce que** la couche sacrificielle comprend de l'AlAs ou est constituée d'AlAs ou que la couche sacrificielle comprend de l'InGaP ou est constituée d'InGaP.

11. Procédé selon une des revendications précédentes, **caractérisé en ce qu'**au moins une ou aucune des couches susmentionnées ne manque dans une zone périphérique, laquelle zone périphérique possède une extension latérale inférieure à 3 % du rayon de la plaquette semi-conductrice.

12. Procédé selon une des revendications précédentes, **caractérisé en ce qu'**entre la couche de support et la couche semi-conductrice est formée une couche diélectrique, laquelle couche diélectrique est structurée de telle sorte que la couche semi-conductrice est mise en contact électrique par le biais de la couche métallique.

13. Procédé selon une des revendications précédentes, **caractérisé en ce que** la couche sacrificielle et la couche tampon comprennent le même matériau ou son constituées du même matériau ou que la couche sacrificielle et la couche tampon présentent possèdent la même stoechiométrie.

14. Procédé selon une des revendications précédentes, **caractérisé en ce que** la forme géométrique et/ou la profondeur des trous sont influencées au moyen d'une commande de la durée et/ou de la puissance du rayon laser.
